# EUROPÄISCHE PATENTSCHRIFT

(11) **EP 2 672 527 B1**
(45) Veröffentlichungstag und Bekanntmachung des Hinweises auf die Patenterteilung: **18.09.2019**
(21) Anmeldenummer: 13169885.4
(22) Anmeldetag: 30.05.2013
(51) Int. Cl.: H01L 31/02, H02S 40/34

(54) **Solarmodul mit einer Steckeinrichtung**
Solar module with a plug-in device
Module solaire doté d'un dispositif d'enfichage

(30) Priorität: 07.06.2012 DE 102012104942
(43) Veröffentlichungstag der Anmeldung: 11.12.2013
(73) Patentinhaber: Hanwha Q CELLS GmbH, 06766 Bitterfeld-Wolfen (DE)
(72) Erfinder: Pfennig, Andreas, 04129 Leipzig (DE); Scherff, Maximilian, 44369 Dortmund (DE)
(74) Vertreter: Reininger, Jan Christian

(56) Entgegenhaltungen:
- EP-A1- 1 006 593
- WO-A1-2010/098685
- DE-A1-102009 039 370
- DE-B3- 10 334 935

## Beschreibung

Die vorliegende Erfindung betrifft ein Solarmodul mit einer Steckeinrichtung. Insbesondere betrifft die vorliegende Erfindung ein Solarmodul mit einer multifunktionalen Steckeinrichtung. Die multifunktionale Steckeinrichtung ermöglicht, dass an dem Solarmodul eine Vielzahl von Gegenständen befestigt werden kann.

Die Befestigung von Solarmodulen an Hausdächern und/oder an Fassaden sowie die Befestigung elektrischer Modulanschlüsse an Solarmodulen und/oder die funktionale Kopplung von Dioden insbesondere als Bypass-Dioden an Solarmodulen erfordert in der Regel eine Vielzahl an Komponenten, die an ein Solarmodul angebracht werden müssen. Neben möglichen Fehlmontagen besteht weiterhin das Problem, dass die angebrachten Komponenten Platz erfordern und so beispielsweise eine Lagerung von Solarmodulen, die fertig hergestellt, lediglich an ein Hausdach und/oder an eine Fassade zu montieren sind, aufgrund ihrer geringen Stapelfähigkeit hohe Lagerungs- und Transportkosten verursachen.

An elektrische Modulanschlüsse werden hohe Anforderungen gestellt. Eine Anschlussdose soll aus möglichst wenig Bauteilen und wenig Material bestehen, um kostengünstig zu sein. Die Verbindungstechnik zwischen der Anschlussdose und dem Solarmodul muss mechanisch flexibel, wasser- und staubdicht und langzeitstabil sein. Die Befestigung elektrischer Modulanschlüsse ist daher problematisch und mit viel Aufwand verbunden.

Modulanschlüsse können beispielsweise als Anschlussdose ausgestaltet sein, die zwei Dioden im Innern und zwei Kabel aufweist und die an der Solarmodulrückseite aufgeklebt ist, wie es in der US 2002 0193001 A1 beschrieben ist. Die Anschlussdose wird aufgeklebt, dann werden die aus dem Solarmodul herausragenden Querverbinder in der Anschlussdose angeschlossen und die Anschlussdose wird dann mit einem Deckel verschlossen. Dabei wird ein vergossenes Steckelement verwendet, das einlaminiert ist, wobei mit dem Ausdruck "vergossen" meint, dass bei dem vulkanisierten Stecker die inneren Komponenten ohne eine Zerstörung des Steckers nicht zugänglich sind.

EP 1 496 577 B1 beschreibt ein Gehäuse für ein Solarmodul, in das eine Bypass-Diode gesteckt ist. Die Bypass-Diode ist daher austauschbar. Das Gehäuse kann an einem Solarzellenmodul befestigt werden.

Neben Solarmodulen mit sogenannten "zentralen Anschlüssen", d.h. die Anschlussdose, die alle Bypass-Dioden enthält, ist zentral angeordnet, können Solarmodule auch sogenannte dezentrale Anschlussdosen aufweisen, die nicht zentral auf dem Solarmodul angeordnet sind, sondern dezentral.

DE 202009007523 U1 beschreibt beispielsweise ein Solarmodul mit aufgeklebten dezentralen Anschlussdosen, die jeweils eine Diode enthalten.

Bei dezentralen elektrischen Modulanschlüssen können sich Bypass-Dioden beispielsweise in den Anschlussdosen oder bei einem Solarmodullaminat im Laminat des Solarmoduls befinden. In beiden Fällen ist die Diode nicht auswechselbar. Im Laminat ist sie nicht erreichbar, ohne das Laminat aufzubrechen. In der Anschlussdose ist sie üblicherweise in Silikon vergossen, um eine Abdichtung zum Solarmodul zu gewährleisten, weil der Modulanschluss abgedichtet sein muss, wie bereits erwähnt. Die Anschlussdosen können daher nicht ohne Beschädigung geöffnet werden. Die Dioden sind höchsten von Fachpersonal auswechselbar. Bei einer solchen Beschädigung geht die Gewährleistung des Anschlussdosenherstellers verloren. Eine defekte Diode kann somit zum Austausch eines Solarmoduls führen und somit hohe Kosten verursachen.

Alternativ kann ein Solarmodul einlaminierte Anschlussdosen aufweisen. Neben den vorstehend erwähnten Problemen der Anschlussdosen besteht hier weiterhin das Problem, dass es aufwändig ist, einen Laminator an die Außenkontur der Anschlussdose für die Einlaminierung derselben anzupassen. In der DE 10 2009 039 370 A1 D1 wird ein Solarmodul mit einem Querverbinder mit einem Flachbaustein zur späteren Montage einer Anschlussdose beschrieben. Der Querverbinder weist den Flachbaustein und Kontaktbänder auf, von denen Teilbereiche in den Flachbaustein eingebettet sind. Eine Rückseitenverkapselungsstruktur weist eine Öffnung auf, in der der Flachbaustein angeordnet ist, so dass er von der Rückseitenverkapselungsstruktur angrenzend umgeben ist. Zwischen dem Flachbaustein und der Rückseitenverkapselungsstruktur können Nässe und Feuchtigkeit eindringen.

EP 1 006 593 A1 beschreibt ein Solarmodul, bei dem ein Steckverbinder in eine Innenplatte einlaminiert ist. Als Materialien der Innenplatte werden Glasscheiben aus anorganischem Glas, lichtundurchlässige, ggf. metallisierte Kunststofffolien oder Folienlaminate eingesetzt, die derart angeordnet sind, dass der Steckverbinder nicht über die Innenplatte hinausragt sondern in die Innenplatte eingepresst ist. Dadurch ist das Solarmodul stapelbar.

Üblicherweise werden Solarmodule mechanisch mittels Klemmen befestigt. Durch die klemmende Befestigung am Rand des Solarmoduls ist die Durchbiegung des Solarmoduls bei Belastungstests sowie im Betrieb mit Flächenlasten wie beispielsweise Wind und Schnee und dynamischer Belastung wie bei einem Sturm vergleichsweise groß. Dadurch, dass sich die mechanisch neutrale Phase des Solarmoduls nicht in der Zellebene befindet, entstehen schädliche Scherkräfte in der Zellebene und/oder Zugspannungen an den Zellverbindern, die zu Zellbruch und Kontaktproblemen führen können. Eine flächige Unterstützung des Solarmoduls kann mit Schienen erfolgen, die aufgeklebt werden. Eine zuverlässige dauerhafte Verbindung ist damit schwer zu erreichen. Daher ist eine andere Befestigungsmöglichkeit wünschenswert.

Es ist eine Aufgabe der vorliegenden Erfindung ein Solarmodul zur Verfügung zu stellen, das eine einfache, stabile und wetterfeste Befestigungsmöglichkeit für verschiedenartige Bauteile bietet, die weiterhin ein leichtes und einfaches Auswechseln der verschiedenartigen Bauteile bietet.

Erfindungsgemäß wird die Aufgabe durch ein Solarmodul nach Anspruch 1 gelöst.

Vorteilhafte Ausgestaltungen der vorliegenden Erfindung sind in den Unteransprüchen angegeben.

Erfindungsgemäß wird ein Solarmodul mit einer Frontseitenoberfläche und einer Rückseitenoberfläche zur Verfügung gestellt. Das Solarmodul weist
- ein die Frontseitenoberfläche des Solarmoduls bildendes Frontseitenverkapselungselement,
- eine Mehrzahl Solarzellen, die elektrisch miteinander verschaltet sind,
- ein die Rückseitenoberfläche des Solarmoduls mit einer Rückseitenoberflächenebene bildendes Rückseitenverkapselungselement, das eine polymere Kunststofffolie aufweist, und
- mindestens eine Steckeinrichtung zur Verbindung mit einer komplementären Struktur auf.

Die Steckeinrichtung ist im Bereich eines Überlappabschnittes zumindest teilweise in das Rückseitenverkapselungselement einlaminiert. Das Rückseitenverkapselungselement weist eine Öffnung auf. Die Steckeinrichtung ist zumindest zum Teil in der Öffnung angeordnet. Die Steckeinrichtung überragt die Rückseitenoberflächenebene des Solarmoduls um höchstens 15mm.

Die Steckeinrichtung steht aus der Rückseitenoberflächenebene des Solarmoduls kaum hervor, sondern ist quer zur Oberfläche betrachtet vergleichsweise flach ausgebildet. Dadurch kann die Steckeinrichtung schon vor einem Laminationsprozess, bei dem das Rückseitenverkapselungselement, auf die Steckeinrichtung bzw. die Solarzellen auflaminiert wird, zumindest teilweise im Bereich eines Überlappabschnittes in das Solarmodul einlaminiert werden, ohne dass ein Umbau handelsüblicher Laminationsanlagen erforderlich wäre. Ggf. kann die Steckeinrichtung, wenn sie einen elektrischen Anschluss aufweist, vor dem Laminationsprozess mit einem Querverbinder kontaktiert werden.

Die Steckeinrichtung ist im Bereich eines Überlappabschnittes in das Rückseitenverkapselungselement einlaminiert. Wenn die Steckeinrichtung einen elektrischen Anschluss aufweist, ist der elektrische Anschluss nicht der Witterung ausgesetzt. D.h., der elektrische Anschluss ist in dem Solarmodul wetterfest eingebaut. Der Ausdruck "wetterfest" bedeutet im Sinne der vorliegenden Erfindung insbesondere, dass der elektrische Anschluss vor Umwelteinflüssen wie Nässe wie beispielsweise Spritzwasser oder eindringende Feuchtigkeit und Schmutz wie beispielsweise Staub in einem Betriebstemperaturbereich von +10°C bis mindestens +60°C geschützt ist. Durch die Einlaminierung der Steckeinrichtung im Bereich eines

Überlappabschnittes in das Rückseitenverkapselungselement werden einerseits Materialien wie Klebepads und Kleber gespart und andererseits wird durch die Integration der Steckeinrichtung in das Rückseitenverkapselungselement die Festigkeit des Verbunds aus Steckeinrichtung und Rückseitenverkapselungselement gesteigert. Die Steckeinrichtung ist durch die zumindest teilweise Einlaminierung in das Rückseitenverkapselungselement vor einem langzeitigen Loslösen oder Abfallen geschützt.

Im Sinne der vorliegenden Erfindung wird unter dem Ausdruck "Steckeinrichtung" eine Einrichtung verstanden, die derart ausgebildet ist, dass sie eine komplementäre Struktur derart aufnehmen kann, dass sie mit dieser verbunden ist. Die Steckeinrichtung bzw. die komplementäre Struktur kann weibliche und/oder männliche Elemente aufweisen.

Im Sinne der vorliegenden Erfindung wird unter dem Ausdruck "Überlappabschnitt" ein Abschnitt verstanden, in dem die Steckeinrichtung in dem Rückseitenverkapselungselement einlaminiert ist, sodass Teile der Steckeinrichtung mit Teilen des Rückseitenverkapselungselements überlappen.

Der Überlappabschnitt ist insbesondere dadurch realisiert, dass die Öffnung des Rückseitenverkapselungselements eine Grundfläche aufweist, die kleiner ist als die Grundfläche der Steckeinrichtung. Bevorzugt weisen die Grundfläche der Öffnung und die Grundfläche der Steckeinrichtung die gleiche Form auf, sind aber unterschiedlich groß. Die im Vergleich zur Grundfläche des Anschlussgehäuses kleinere Grundfläche der Öffnung stellt sicher, dass die Steckeinrichtung zumindest in dem Überlappabschnitt fest in das Rückseitenverkapselungselement einlaminiert ist. Der Überlappabschnitt weist bevorzugt eine konstante Breite auf. Die konstante Breite des Überlappabschnitts hat den Vorteil, dass mechanische Spannungen zwischen dem Anschlussgehäuse und dem Rückseitenverkapselungselement räumlich gleichmäßig auf das Solarmodul einwirken und somit für die Langzeitstabilität des Solarmoduls von Vorteil ist.

Das Rückseitenverkapselungselement weist eine polymere Kunststofffolie auf. Bevorzugt weist das Rückseitenverkapselungselement ein Einbettungspolymer und eine Rückseitenverkapselungsstruktur auf. Das Einbettungspolymer ist vorzugsweise auf der Steckeinrichtung bzw. der Mehrzahl Halbleiterwafer-Solarzellen und die Rückseitenverkapselungsstruktur auf dem Einbettungspolymer angeordnet. Die Steckeinrichtung ist vorzugsweise in das Einbettungspolymer einlaminiert. Als Einbettungspolymer kommt insbesondere Ethylenvinylacetat in Frage. Weitere Beispiele für das Einbettungspolymer sind Silikongummi, Polyvinylbutyral, Polyurethan oder Polyacrylat. Ein Beispiel für die Rückseitenverkapselungsstruktur ist beispielsweise eine Rückseitenfolie aus TEDLAR® (eingetragenes Markenzeichen der DuPont, Wilmington, USA).
Das Frontseitenverkapselungselement kann ein Einbettungspolymer und eine Frontseitenverkapselungsstruktur aufweisen. Das Einbettungspolymer kann aus den vorstehend aufgezählten Beispielen für das Einbettungspolymer des Rückseitenverkapselungselements ausgewählt werden. Die Frontseitenverkapselungsstruktur ist üblicherweise aus Glas aufgebaut, kann aber auch hinreichend transparente Kunststoffe umfassen.

Bevorzugt ist das Einbettungspolymer auch zwischen der Steckeinrichtung und Solarzellen angeordnet. D.h. eine Einbettungspolymer-Laminatschicht befindet sich zwischen der Steckeinrichtung und Solarzellen. Das vorstehende Einbettungspolymer kann aus den vorstehend aufgezählten Beispielen für das Einbettungspolymer des Rückseitenverkapselungselements ausgewählt werden und ist vorzugsweise derart ausgewählt, dass es das gleiche Material ist, das für das Einbettungspolymer des Rückseitenverkapselungselements verwendet wird.

Die Solarzellen sind vorzugsweise Halbleiterwafer-Solarzellen wie beispielsweise Silizium-Solarzellen.

Bevorzugt überragt die Steckeinrichtung die Rückseitenoberflächenebene des Solarmoduls um höchstens 6mm. Noch bevorzugter überragt die Steckeinrichtung die Rückseitenoberflächenebene des Solarmoduls um höchstens 4mm. Je weniger die Steckeinrichtung die Rückseitenoberflächenebene überragt, desto besser kann die Steckeinrichtung in das Rückseitenverkapselungselement mit einlaminiert werden. Die Steckeinrichtung überragt das Rückseitenoberflächenebene vorzugsweise um mindestens 1 mm.

In einer bevorzugten Ausführungsform weist die Steckeinrichtung in Richtung senkrecht zur Rückseitenoberfläche eine maximale Höhe auf, die kleiner 10% von einem Durchmesserdurchschnittswert ist, der aus einem maximalen Durchmesser und aus einem minimalen Durchmesser der Steckeinrichtung gebildet ist, die sich in der Aufsicht auf die Rückseitenoberflächenebene darstellen. Bevorzugter weist die Steckeinrichtung in Richtung senkrecht zur Rückseitenoberfläche eine maximale Höhe auf, die kleiner 8% von einem Durchmesserdurchschnittswert ist, der aus einem maximalen Durchmesser und aus einem minimalen Durchmesser der Steckeinrichtung gebildet ist. Noch bevorzugter weist die Steckeinrichtung in Richtung senkrecht zur Rückseitenoberfläche eine maximale Höhe auf, die kleiner 5% von einem Durchmesserdurchschnittswert ist, der aus einem maximalen Durchmesser und aus einem minimalen Durchmesser der Steckeinrichtung gebildet ist, die sich in der Aufsicht auf die Rückseitenoberflächenebene darstellen. D.h., die Steckeinrichtung ist im Vergleich zu seiner geometrischen Erstreckung in den Richtungen der Rückseitenoberflächenebene sehr flach ausgebildet.

Bevorzugt weist die Steckeinrichtung ein Gehäuse auf. Alternativ bildet die Steckeinrichtung selbst ein Gehäuse aus. Wenn die Steckeinrichtung nur ein Gehäuse ausbildet, d.h. keine weiteren, insbesondere elektrischen Komponenten enthält, dann eignet sie sich insbesondere als Montagepunkt zur mechanischen Solarmodulbefestigung. Vorteilhaft weist eine planparallel zur Rückseitenoberflächenebene ausgebildete Kontaktfläche mindestens eine Öffnung auf, die geeignet ist, eine komplementäre Struktur, d.h. eine Struktur mit mindestens einem Vorsprung, derart aufzunehmen, dass die komplementäre Struktur fest verankert ist, jedoch wenn erforderlich, beispielsweise wenn das Solarmodul defekt ist, wieder lösbar ist. Die Steckeinrichtung kann alternativ oder zusätzlich mindestens einen Vorsprung aufweisen. Geeignet weist in diesem Fall die komplementäre Struktur entsprechend alternativ oder zusätzlich mindestens eine Öffnung auf. Alternativ oder zusätzlich können die Steckeinrichtung und die komplementäre Struktur Rastelemente aufweisen.

In einer bevorzugten Ausführungsform weist die Steckeinrichtung mindestens einen ersten Kontakt, der mit den Solarzellen elektrisch verschaltet ist, und mindestens einen zweiten Kontakt auf, der geeignet ist, von der komplementären Struktur kontaktiert zu werden. Die komplementäre Struktur ist dann bevorzugt als Stecker ausgebildet, der über den zweiten Kontakt eine elektrische Kontaktierung der Solarzellen des Solarmoduls herstellt. Der erste und der zweite Kontakt können einstückig ausgebildet sein. Die Steckeinrichtung ist in dieser Ausführungsform geeignet, mit einer Diode in einem Stecker, einer Chipkarte oder dergleichen verbunden zu werden. Vorzugsweise ist die Diode über den Stecker oder die Chipkarte mit der Steckeinrichtung lösbar verbunden. In diesem Fall ist die Diode leicht auswechselbar, da sie nicht in dem Solarmodul einlaminiert ist, sondern mit dem Stecker oder der Chipkarte in die Steckeinrichtung gesteckt ist.

Vorzugsweise weist die Steckeinrichtung mindestens einen elektrischen Anschluss, mindestens eine Diode und/oder mindestens eine Bypass-Diode auf.

Dadurch, dass die Steckeinrichtung teilweise nämlich im Bereich eines Überlappabschnittes in das Rückseitenverkapselungselement einlaminiert ist, kann sie nicht abfallen. Die Steckeinrichtung ist in diesem Fall derart ausgebildet, dass sie mit mindestens zwei Querverbindern des Solarmoduls verschaltet ist. Die komplementäre Struktur kann in diesem Fall ein Kabel mit einem zur Steckeinrichtung komplementärem Steckgesicht an einem Ende sein, wobei das Kabel vorzugsweise unlösbar mit der Steckeinrichtung zu verbinden ist.

In einer bevorzugten Ausführungsform weist die Steckeinrichtung eine Kontaktfläche zur Verbindung der komplementären Struktur auf, die planparallel zu oder in der Rückseitenoberflächenebene angeordnet ist.

In einer bevorzugten Ausführungsform weist die Steckeinrichtung eine Kontaktfläche zur Verbindung der komplementären Struktur auf, die planparallel zu oder in der Rückseitenoberflächenebene angeordnet ist. Diese Ausführungsform ist vorteilhaft, wenn die Steckeinrichtung als ein Gehäuse ausgebildet ist, mindestens eine Öffnung und/oder mindestens ein Rastelement aufweist und als Montagepunkt zur Befestigung des Solarmoduls dient. Die komplementäre Struktur kann in diesem Fall winkelig vorzugsweise senkrecht in die mindestens eine Öffnung oder das mindestens eine Rastelement eingeführt werden. Weiterhin kann die Steckeinrichtung in dieser Ausführungsform auch einen elektrischen Anschluss, eine Diode und/oder eine Bypass-Diode, einen elektronischen Schaltkreis oder andere elektrische Kontakte aufweisen.

Die elektrischen Kontakte, der elektrische Anschluss, die Diode und/oder die Bypass-Diode können derart ausgerichtet sein, dass sie planparallel zu der Rückseitenoberflächenebene elektrisch kontaktiert werden können, sie können jedoch auch anders ausgerichtet sein. Beispielsweise ist es möglich, dass die Kontaktfläche planparallel zur Rückseitenoberflächenebene ausgebildet ist und mindestens eine Öffnung und/oder mindestens ein Rastelement aufweist, der elektrische Kontakt, der elektrische Anschluss, die Diode und/oder die Bypass-Diode aber nicht in der Kontaktfläche angeordnet sind.

Bevorzugt weist das Gehäuse mindestens zwei Teile auf. Mindestens ein einlaminierter Bereich von zumindest einem Teil weist mindestens eine Öffnung auf, die eine kraftschlüssige Verbindung zwischen den Teilen des Gehäuses gestattet. Diese Ausführungsform ist vorteilhaft, wenn die Steckeinrichtung neben dem Gehäuse noch weitere Komponenten wie einen elektrischen Kontakt, einen elektrischen Anschluss, eine Diode und/oder eine Bypass-Diode aufweist. Diese Komponenten können zwischen die mindestens zwei Teile des Gehäuses gelegt werden und staub- und wasserdicht in dem Gehäuse eingeschlossen werden.

In einer weiteren bevorzugten Ausführungsform weist die Steckeinrichtung in einem Einlaminierungsbereich, in dem die Steckeinrichtung in das Rückseitenverkapselungselement einlaminiert ist, Vertiefungen auf, die geeignet sind, um Rückseitenverkapselungselementmaterial aufzunehmen. Während der Einlaminierung der Steckeinrichtung in das Rückseitenverkapselungselement kann es je nach Auswahl des Materials oder der Materialien für das Rückseitenverkapselungselement vorkommen, dass das Rückseitenverkapselungsmaterial während des Laminierens quillt und senkrecht zur Rückseitenoberflächenebene hervorsteht, d.h. an den Seiten des Solarmoduls hervorquillt. Dies kann beispielsweise der Fall sein, wenn das Rückseitenverkapselungsmaterial ein Einbettungspolymer wie beispielsweise Ethylenvinylacetat und eine Rückseitenverkapselungsstruktur wie beispielsweise eine Glasplatte oder Kunststofffolie aufweist. Während des Laminationsprozesses kann das Einbettungspolymer, das zwischen der Steckeinrichtung bzw. den Solarzellen und der Rückseitenverkapselungsstruktur angeordnet ist, in dem Bereich der Öffnungen der Rückseitenverkapselungsstruktur aus dem Solarmodul hervorquellen. Um dies zu verhindern, weist die Steckeinrichtung bevorzugt in dem Einlaminierungsbereich, in dem die Steckeinrichtung in das Rückseitenverkapselungselement einlaminiert wird, Vertiefungen auf, die geeignet sind, um das Einbettungspolymer, wenn erforderlich, aufzunehmen. Im Sinne der vorliegenden Erfindung wird unter dem Ausdruck "Einlaminierungsbereich" ein Bereich verstanden, an dem die Einlaminierung der Steckeinrichtung in das Rückseitenverkapselungselement endet und der von dem Rückseitenverkapselungselement unbedeckte, sprich nicht-einlaminierte, Bereich der Steckeinrichtung beginnt. Ein Einlaminierungsbereich umfasst daher einen Endbereich eines Überlappabschnittes, an den ein Übergangsbereich grenzt. Ein Übergangsbereich ist im Sinne der vorliegenden Erfindung ein Bereich, der den Übergang eines einlaminierten Teils der Steckeinrichtung und eines unbedeckten Teils der Steckeinrichtung darstellt.

Bevorzugt weist die Steckeinrichtung mindestens einen Abstandshalter auf, der sich zwischen Solarzellen erstreckt und sich auf dem Frontseitenverkapselungselement abstützt. Dadurch wird die Anordnung der Steckeinrichtung im Laminatverbund mechanisch stabilisiert und leitet Kräfte in Richtung des Frontseitenverkapselungselements ab.

In einer bevorzugten Ausführungsform umfasst das Solarmodul weiterhin die komplementäre Struktur. Die komplementäre Struktur ist mit der Steckeinrichtung verbunden. Die komplementäre Struktur ist in Abhängigkeit der Steckeinrichtung ausgebildet. Wenn die Steckeinrichtung bzw. ihre Kontaktfläche mindestens eine Öffnung aufweist, weist die komplementäre Struktur mindestens einen dementsprechend komplementären Vorsprung auf und umgekehrt.

Die komplementäre Struktur kann beispielsweise als ein Untergestell ausgebildet sein, das geeignet ist, an eine Tragkonstruktion, ein Hausdach und/oder eine Fassade angebracht zu werden. In diesem Fall weist das Untergestell bevorzugt eine vorbestimmte Anzahl an Vorsprüngen auf, die geeignet sind, mit der vorbestimmten Anzahl an Steckeinrichtungen - vorzugsweise kraftschlüssig - verbunden zu werden. Vorzugsweise ist die vorbestimmte Anzahl an Vorsprüngen gleich zu der vorbestimmten Anzahl an Steckeinrichtungen.

Die komplementäre Struktur kann alternativ als ein Stecker ausgebildet sein, der elektrische Kontakte und/oder eine auswechselbare Diode aufweist. Der Stecker kann mit einem Kabel verbunden sein. Der Stecker kann Abmessungen aufweisen, die erlauben, dass er zumindest teilweise in eine Öffnung der Steckeinrichtung gesteckt werden kann und zur Verbindung mit der Steckeinrichtung derart gedreht wird, dass er zumindest teilweise unter zur Öffnung angrenzenden Bereichen in der Steckeinrichtung angeordnet ist und durch Drehen in die Abmessungen der Öffnung und Herausnehmen wieder aus der Steckeinrichtung entfernt werden kann.

Weiterhin alternativ kann die komplementäre Struktur als eine Chipkarte ausgebildet sein. In diesem Fall befinden sich elektrische Kontakte und/oder eine auswechselbare Diode und/oder Bypass-Diode in einem sehr flachen Gehäuse, d.h. einem kartenförmigen Gehäuse. Die Chipkarte ist derartig ausgebildet, dass sie in die Steckeinrichtung gesteckt und mit ihr verankert werden kann.

Erfindungsgemäß kann die komplementäre Struktur einen elektrischen Kontakt und/oder eine Bypass-Diode aufweisen und/oder die Steckeinrichtung enthält einen elektrischen Anschluss und/oder eine Bypass-Diode.

In einer vorteilhaften Ausführungsform weist die komplementäre Struktur eine auswechselbare Diode auf und weist die Steckeinrichtung zwei Kontakte auf, die mit der Diode in der komplementären Struktur kontaktiert werden. Die komplementäre Struktur kann ein Stecker oder eine Chipkarte sein. Die elektrischen Kontakte der Steckeinrichtung sind mit mindestens zwei Querverbindern verbunden.

In einer alternativen Ausführungsform weist die Steckeinrichtung eine Diode auf und weist die komplementäre Struktur elektrische Kontakte auf. Wenn die Steckeinrichtung derart ausgestaltet ist, dass sie sich öffnen lässt, sind die Dioden in der Steckeinrichtung auswechselbar.

Die Verbindung zwischen Steckeinrichtung und komplementärer Struktur kann über Drehen oder Schieben hergestellt sein. Vorzugsweise ist die Verbindung form- und/oder kraftschlüssig.

Wenn die Verbindung über Schieben erfolgt, können die Steckeinrichtung und die komplementäre Struktur vorzugsweise weiterhin Einrastelemente aufweisen, die verhindern, dass sich die Verbindung lösen kann.

In einer bevorzugten Ausführungsform sind die komplementäre Struktur und die Steckeinrichtung bajonettverschlussartig miteinander verbunden. Der Bajonettverschluss gewährleistet eine schnell herstell- und lösbare mechanische Verbindung zwischen der Steckeinrichtung und der komplementären Struktur. Die Steckeinrichtung und die komplementäre Struktur werden durch Ineinanderstecken und entgegengesetztes Drehen verbunden und so auch wieder getrennt. Beispielsweise weist die komplementäre Struktur einen Längsschlitz auf, an dessen Ende sich rechtwinklig ein kurzer Querschlitz ansetzt, und weist die Steckeinrichtung einen Knopf auf, der in den Querschlitz eingeführt wird oder umgekehrt. Die bajonettverschlussartige Verbindung erfolgt über eine Steck-Dreh-Bewegung. Die Steckeinrichtung und die komplementäre Struktur werden ineinander gesetzt; annähernd senkrecht zur Steckrichtung sind in der Steckeinrichtung und der komplementären Struktur an der Verbindungsstelle längliche Erhebungen angebracht. Diese laufen jedoch nicht rundum, sondern sind unterbrochen. Da die Erhebungen nun leicht schräg in der Ebene senkrecht zur Steckrichtung liegen, werden durch eine Drehbewegung die Steckeinrichtung und die komplementäre Struktur quasi gewindeartig gegeneinandergepresst. Alternativ zu den Erhebungen an der Steckeinrichtung und der komplementären Struktur kann auch die Steckeinrichtung mindestens eine Einbuchtung und die komplementäre Struktur mindestens eine komplementäre Ausbuchtung oder umgekehrt aufweisen. Wenn erforderlich, kann die Verbindung weiterhin mittels Einrastelementen, die an der Steckeinrichtung und der komplementären Struktur angeordnet sind, gesichert werden. Vorzugsweise weist die Steckeinrichtung und/oder die komplementäre Struktur eine Dichtung auf, die derart gestaltet ist, dass der Verbindungsbereich, in dem die komplementäre Struktur mit der Steckeinrichtung verbindbar ist, abgedichtet ist. Diese Ausführungsform stellt sicher, dass weder Staub noch Wasser in zwischen die Steckeinrichtung und die komplementäre Struktur eindringen. Dies ist insbesondere wichtig, wenn die Steckeinrichtung und/oder die komplementäre Struktur mindestens einen elektrischen Kontakt, elektrischen Anschluss, Diode und/oder Bypass-Diode aufweisen.

In einer bevorzugten Ausführungsform weist die Steckeinrichtung und/oder die komplementäre Struktur ein Abdichtungselement auf, das derart angeordnet ist, dass es einen Übergangsbereich abdeckt, der den Übergang eines einlaminierten Teils der Steckeinrichtung und eines unbedeckten Teils der Steckeinrichtung darstellt. Das Abdichtungselement verhindert das Eindringen von Wasser und/oder Staub. Das Eindringen von Staub bzw. Feuchtigkeit kann zu einem langsamen Ablösen der Laminationsschichten führen.

Vorzugsweise enthält die komplementäre Struktur mindestens einen elektrischen Anschluss, mindestens eine Diode und/oder mindestens eine Bypass-Diode. Die Diode und/oder Bypass-Diode können fest in die komplementäre Struktur integriert sein oder als auswechselbare Bauteile ausgestaltet sein. Im letzten Fall kann die komplementäre Struktur mehrteilig sein.

Bevorzugt ist die Steckeinrichtung und/oder die komplementäre Struktur unlösbar mit mindestens einem Kabel verbunden. Insbesondere ist die Steckeinrichtung mit mindestens einem Kabel verbunden, wenn sie einen elektrischen Anschluss, eine Diode und/oder eine Bypass-Diode aufweist. Das Kabel weist dann an einem Ende die komplementäre Struktur auf, die mit der Steckeinrichtung verbunden ist. Alternativ oder zusätzlich kann die komplementäre Struktur mit einem Kabel unlösbar verbunden sein, wenn sie weiterhin einen elektrischen Anschluss, eine Diode und/oder eine Bypass-Diode aufweist.

Die vorliegende Erfindung wird nun unter Bezugnahme auf Figuren detaillierter erläutert, ohne die Erfindung darauf einzuschränken. Alle Figuren sind schematisch und nicht maßstabsgerecht. In den Figuren verwendete gleiche Bauteile weisen die gleichen Bezugszeichen auf.

Die Figuren zeigen:
Fig. 1 eine Teil-Aufsicht auf die Rückseite eines erfindungsgemäßen Solarmoduls;
Fig. 2 eine Teil-Querschnittsansicht des in Fig. 1 gezeigten Solarmoduls;
Fig. 3 eine Teil-Aufsicht auf die Rückseite eines weiteren erfindungsgemäßen Solarmoduls;
Fig. 4 eine vergrößerte Teil-Aufsicht auf die Rückseite des in Fig. 3 gezeigten Solarmoduls;
Fig. 5 eine Teil-Querschnittsansicht des in Fig. 3 gezeigten Solarmoduls;
Fig. 6 eine Teil-Querschnittsansicht eines weiteren erfindungsgemäßen Solarmoduls;
Fig. 7 eine Teil-Querschnittsansicht eines weiteren erfindungsgemäßen Solarmoduls;
Fig. 8 eine Teil-Querschnittsansicht eines weiteren erfindungsgemäßen Solarmoduls;
Fig. 9 eine Aufsicht auf ein weiteres erfindungsgemäßes Solarmodul; und
Fig. 10 eine Teil-Querschnittsansicht eines weiteren erfindungsgemäßen Solarmoduls.

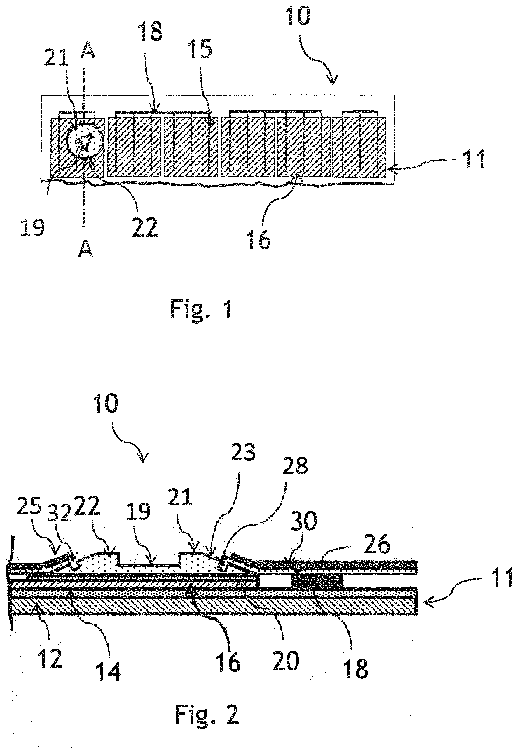

Fig. 1 zeigt eine Teil-Aufsicht auf die Rückseite eines erfindungsgemäßen Solarmoduls 10. In der Teil-Aufsicht auf das Solarmodul 10 ist das Rückseitenverkapselungselement nicht gezeigt. Eine Vielzahl von Solarzellen 16 (von denen sechs exemplarisch gezeigt sind) sind auf einem Frontseitenverkapselungselement 11 angeordnet und mittels Querverbindern 18 miteinander elektrisch verschaltet. Die Querverbinder 18 sind mit Busbars 15 elektrisch verschaltet, die sich auf den Solarzellen 16 erstrecken. Auf einer Solarzelle 16 ist eine Steckeinrichtung 22 angeordnet. Die Steckeinrichtung 22 ist mit einem Bodenbereich flächig in der durch die im Wesentlichen zweidimensionale Erstreckung des Solarmoduls definierten Rückseitenoberflächenebene ausgebildet. Die Steckeinrichtung 22 ist teilweise in ein Rückseitenverkapselungselement einlaminiert, das in der Fig. 1 aus Gründen der Übersichtlichkeit transparent - also nicht erkennbar dargestellt ist. Der nicht einlaminierte Teil der Steckeinrichtung 22 bildet eine Kontaktfläche 21, die planparallel zur Rückseitenoberflächenebene ausgebildet ist. Die Kontaktfläche 21 ist in dem Aufnahmebereich 19 zur Aufnahme einer komplementären Struktur geeignet. Die Steckeinrichtung 22 kann elektrische Kontakte, einen elektrischen Anschluss, eine Diode und/oder eine Bypass-Diode enthalten. Weiterhin kann das Solarmodul 10 weitere Steckeinrichtungen 22 aufweisen, falls erforderlich.

Fig. 2 zeigt schematisch eine nicht maßstabsgerechte Teil-Querschnittsansicht des in Fig. 1 gezeigten erfindungsgemäßen Solarmoduls 10. Fig. 2 ist eine Querschnittsansicht entlang des in Fig. 1 gezeigten Schnitts entlang der Linie A-A. Das Solarmodul 10 weist das Frontseitenverkapselungselement 11 auf, das eine Glasplatte 12 und eine Einbettungspolymerschicht 14 umfasst, die beispielsweise Ethylenvinylacetat aufweist. Auf der Einbettungspolymerschicht 14 ist die Solarzelle 16 angeordnet, die mittels Zellverbindern (nicht gezeigt) mit weiteren Solarzellen zu Zellstrings verschaltet sind. Parallel liegende Zellstrings werden mittels Querverbinder 18 elektrisch verschaltet. Optional ist unter der Steckeinrichtung 22 eine Schicht 20, die beispielsweise aus dem Einbettungspolymer wie beispielsweise Ethylenvinylacetat besteht, angeordnet. Die Steckeinrichtung 22 ist auf der optionalen Schicht 20 oder direkt auf einer Solarzelle 16 angeordnet. Ein Rückseitenverkapselungselement 26 bedeckt die Steckeinrichtung 22 teilweise nämlich im Bereich von Überlappabschnitten 25 und weist ein Einbettungspolymer 28 wie beispielsweise Ethylenvinylacetat und eine Rückseitenverkapselungsstruktur 30 wie beispielsweise eine TEDLAR®-Folie auf.

Die Steckeinrichtung 22 weist eine Kontaktfläche 21 auf, die planparallel zur Rückseitenoberflächenebene ausgebildet ist und die geeignet ist, um eine komplementäre Struktur aufzunehmen. In der Kontaktfläche befindet sich der Aufnahmebereich 19 in Form einer Aussparung zur Aufnahme einer komplementären Struktur. Ferner weist die Steckeinrichtung 22, zwei Seitenflächen 23 auf, die jeweils eine Öffnung 32 aufweisen. Die Öffnung 32 ist geeignet, während des Laminationsvorgangs fließendes Einbettungspolymer 28 aufzunehmen, wenn erforderlich. Beispielhaft ist in Fig. 2 gezeigt, dass die Öffnung 32 in Aufsicht auf die Fig. 2 auf der linken Seite nicht mit Einbettungspolymer 28 gefüllt ist und die Öffnung 32 in Aufsicht auf die Fig. 2 auf der rechten Seite mit Einbettungspolymer 28 gefüllt ist. Ob die Öffnung 32 mit dem Einbettungspolymer gefüllt ist oder nicht hängt davon ab, ob während des Herstellungsprozesses des Solarmoduls das Einbettungspolymer 28 derart quillt, um die Öffnung 32 zu füllen oder nicht. Die Steckeinrichtung 22 ist teilweise nämlich im Bereich von Überlappabschnitten 25 in das Rückseitenverkapselungselement 26 einlaminiert. Insbesondere sind die Seiten 23 der Steckeinrichtung 22 teilweise nämlich im Bereich der Überlappabschnitte 25 in das Rückseitenverkapselungselement 26 einlaminiert, sodass die Öffnungen 32 das Einbettungspolymer 28 aufnehmen können, wenn erforderlich.

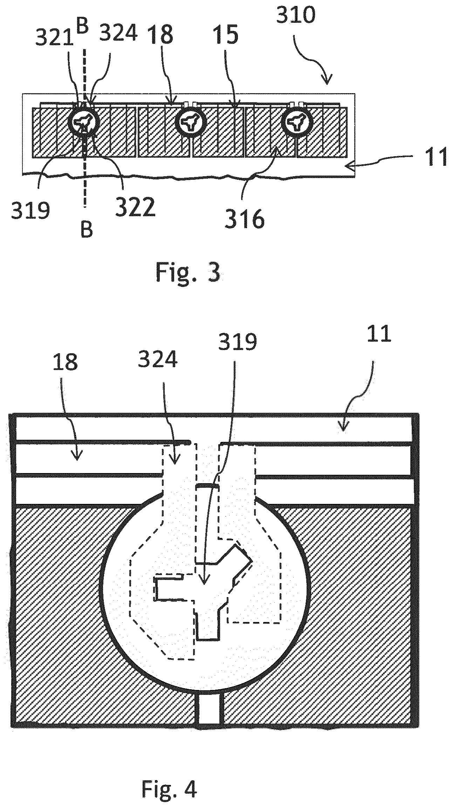

Fig. 3 zeigt eine Teil-Aufsicht auf die Rückseite eines erfindungsgemäßen Solarmoduls 310. In der Teil-Aufsicht auf das Solarmodul 310 ist das Rückseitenverkapselungselement nicht gezeigt. Eine Vielzahl von Solarzellen 16 (von denen sechs exemplarisch gezeigt sind) sind auf einem Frontseitenverkapselungselement 11 angeordnet und mittels Querverbindern 18 miteinander elektrisch verschaltet. Die Querverbinder 18 sind mit Busbars 15 elektrisch verschaltet, die sich auf den Solarzellen 16 erstrecken. Auf den Solarzellen 16 ist eine Steckeinrichtung 322 (von denen drei gezeigt sind) angeordnet. Die Steckeinrichtung 322 ist teilweise in ein Rückseitenverkapselungselement einlaminiert, das in der Fig. 3 aus Gründen der Übersichtlichkeit transparent - also nicht erkennbar dargestellt ist. Der nicht einlaminierte Teil der Steckeinrichtung 322 bildet eine Kontaktfläche 321, die planparallel zur Rückseitenoberflächenebene ausgebildet ist. Die Kontaktfläche 321 ist in dem Aufnahmebereich 319 zur Aufnahme einer komplementären Struktur geeignet. Die Steckeinrichtung 322 enthält elektrische Kontakte 324, die mit den Querverbinder 18 kontaktiert sind.

Fig. 4 zeigt schematisch eine nicht maßstabsgerechte Teil-Aufsicht des in Fig. 3 gezeigten Solarmoduls 310. In Fig. 4 sind die elektrischen Kontakte 324 gezeigt, die die Querverbinder 18 elektrisch kontaktieren. Da sich die elektrischen Kontakte 324 in der Steckeinrichtung 322 befinden und von dieser in der Aufsicht verdeckt sind, sind sie gestrichelt eingezeichnet. Teile der elektrischen Kontakte 324, die sich in dem Aufnahmebereich 319 der Steckeinrichtung 322 befinden, sind jedoch in Aufsicht sichtbar, da der Aufnahmebereich 319 eine Aussparung in der Steckeinrichtung 322 darstellt. Der Aufnahmebereich 319 und die elektrischen Kontakte 324 sind derart ausgestaltet, dass eine komplementäre Struktur, die beispielsweise eine Diode aufweist, mit ihnen kontaktiert werden kann, d.h., die elektrischen Komponenten der Steckeinrichtung 322 und der komplementären Struktur werden miteinander verbunden und der Aufnahmebereich 319 und die komplementäre Struktur werden beispielsweise mittels Stecken miteinander verbunden.

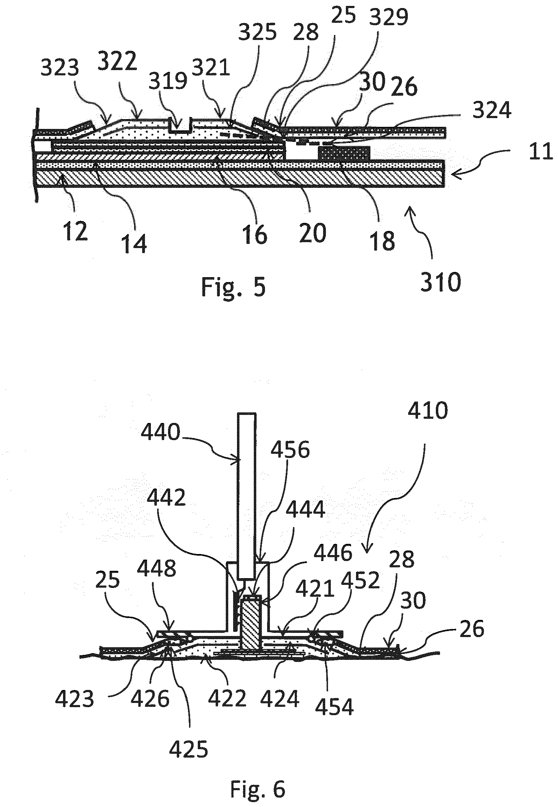

Fig. 5 zeigt schematisch eine nicht maßstabsgerechte Teil-Querschnittsansicht des in Fig. 3 gezeigten Solarmoduls 310 entlang des Schnitts der Linie B-B.

Das Solarmodul 310 weist das Frontseitenverkapselungselement 11 auf, das eine Glasplatte 12 und eine Einbettungspolymerschicht 14 umfasst, die beispielsweise Ethylenvinylacetat aufweist. Auf der Einbettungspolymerschicht 14 ist die Solarzelle 16 angeordnet, die mittels Zellverbindern 18 mit weiteren Solarzellen zu Zellstrings verschaltet ist (nicht gezeigt). Optional ist unter der Steckeinrichtung 322 eine Schicht 20, die beispielsweise aus dem Einbettungspolymer wie beispielsweise Ethylenvinylacetat besteht, angeordnet. Die Steckeinrichtung 322 ist auf der optionalen Schicht 20 oder direkt auf einer Solarzelle 16 angeordnet. Ein Rückseitenverkapselungselement 26 bedeckt die Steckeinrichtung 322 teilweise nämlich im Bereich von Überlappabschnitten 25 und weist ein Einbettungspolymer 28 wie beispielsweise Ethylenvinylacetat und eine Rückseitenverkapselungsstruktur 30 wie beispielsweise eine TEDLAR®-Folie auf.

Die Steckeinrichtung 322 umfasst ein Gehäuse, das Seitenbereiche 323 aufweist, die teilweise nämlich im Bereich der Überlappabschnitte 25 in das Rückseitenverkapselungselement 26 einlaminiert sind. Weiterhin weist die Steckeinrichtung 322 eine Kontaktfläche 321 auf, die planparallel zu der Rückseitenoberflächenebene ausgebildet ist und die einen Aufnahmebereich 319 in Form einer Aussparung aufweist, die zur Aufnahme einer komplementären Struktur geeignet ist und mit dieser kraftschlüssig verbunden werden kann. Die Steckeinrichtung 322 weist eine Öffnung 329 auf, durch die die elektrischen Kontakte 324 der Steckeinrichtung 322 aus dem Gehäuse in das Innere des Solarmoduls 310 geführt sind und mit Querverbindern 18 elektrisch verschaltet sind. Die durch die Öffnung 329 geführten elektrischen Kontakte 324 sind von der Solarzelle 16 üblicherweise isoliert. Für den Fall, dass die der Steckeinrichtung 322 zugewandte Seite der Solarzelle 16 mit dem Querverbinder 18 verschaltet ist, also das selbe elektrische Potenzial aufweist, kann aber auch ein elektrischer Kontakt bestehen. In dem Aufnahmebereich 319 befindet sich weiterhin eine Öffnung (nicht gezeigt), die zur Verschaltung des elektrischen Anschlusses 324 mit einer externen Vorrichtung wie einer Steckereinrichtung geeignet ist, wobei diese Öffnung wasser- und staubdicht ausgebildet ist.

Fig. 6 zeigt eine Teil-Querschnittsansicht eines weiteren erfindungsgemäßen Solarmoduls 410. Der Veranschaulichung halber ist nur die Steckeinrichtung 422 gezeigt, die in ein Rückseitenverkapselungselement 26 einlaminiert ist, das ein Einbettungspolymer 28 und eine Rückseitenverkapselungsstruktur 30 aufweist. Die Steckeinrichtung 422 weist ein Gehäuse mit Seiten 423 auf, die teilweise nämlich im Bereich von Überlappabschnitten 25 in das Rückseitenverkapselungselement 26 einlaminiert sind. Weiterhin weist die Steckeinrichtung 422 zwei elektrische Kontakte 424 auf, die mit einer Diode in einem Steckereinsatz, nachfolgend als Diode 444 bezeichnet, verschaltet sind. Zum Schutz der Diode 444 ist weiterhin ein Berührungsschutz 446 angeordnet. Weiterhin grenzen Einlaminierungsbereiche 426 des Überlappabschnittes 25, an denen die Einlaminierung der Steckeinrichtung 422 in das Rückseitenverkapselungselement 26 endet und der unbedeckte Bereich der Steckeinrichtung 422 beginnt, d.h. Endbereiche der Überlappabschnitte 25 der Seiten 423 und des Rückseitenverkapselungselements 26, an Übergangsabschnitte 425, die den Übergang eines einlaminierten Teils der Steckeinrichtung 422 und eines unbedeckten Teils der Steckeinrichtung 422 darstellen. Die Übergangsabschnitte 425 sind durch ein Abdichtmittel 454 wie einem Kleber geschützt. Das Abdichtmittel 454 hat weiterhin die Funktion Verblendungsbereiche 448, die mit den Seiten 423 zu verkleben. Die Verblendungsbereiche 448 sind an Seitenbereichen eines Gehäuses 456 angeordnet, das die Diode 444, den Berührungsschutz 446,einen Kontakt 442 und ein Kabel 440 ggf. teilweise umhüllt und auf einer Kontaktfläche 421 der Steckeinrichtung 422 aufliegt, sodass die Diode 444 und der Berührungsschutz 446 in einen Aufnahmebereich (nicht gezeigt) der Steckeinrichtung 422 zur Verbindung mit einer komplementären Struktur eingeführt sind und mindestens einen elektrischen Kontakt 424 der Steckeinrichtung 422 kontaktieren. An dem Übergangsbereich zwischen dem Gehäuse 456 und der Steckeinrichtung 422 ist ein Dichtmittel 452 vorzugsweise in der Form eines Klebers angeordnet. Die Diode 444 ist mit einem Kontakt 442 eines Kabels 440 verschaltet. Die Diode 444, der Berührungsschutz 446, das Kabel 440, der Kontakt 442 und das Gehäuse 456 sind Teil der komplementären Struktur, die mit der Steckeinrichtung 422 verbunden ist. Die Verbindung der komplementären Struktur und der Steckeinrichtung 422 ist bajonettverschlussartig, sodass sie stabil aber lösbar miteinander verbunden sind.

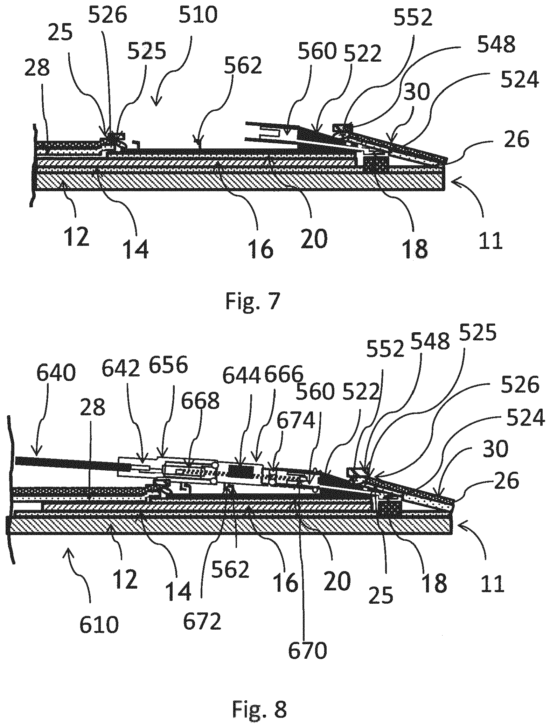

Fig. 7 zeigt eine Teil-Querschnittsansicht eines weiteren erfindungsgemäßen Solarmoduls 510. Das Solarmodul 510 weist ein Frontseitenverkapselungselement 11 auf, das eine Glasplatte 12 und eine Einbettungspolymerschicht 14 umfasst, die beispielsweise Ethylenvinylacetat aufweist. Auf der Einbettungspolymerschicht 14 ist die Solarzelle 16 angeordnet, die mittels Zellverbindern (nicht gezeigt) mit weiteren Solarzellen zu Zellstrings verschaltet sind. Parallel liegende Zellstrings werden mittels Querverbinder 18 elektrisch verschaltet. Das Solarmodul 510 weist weiterhin eine Steckeinrichtung 522 auf, die auf einer optionalen Schicht 20, die beispielsweise aus dem Einbettungspolymer wie beispielsweise Ethylenvinylacetat besteht, oder direkt auf einer Solarzelle 16 angeordnet ist. Das Rückseitenverkapselungselement 26 bedeckt die Steckeinrichtung 522 teilweise nämlich im Bereich von Überlappabschnitten 25 und weist ein Einbettungspolymer 28 wie beispielsweise Ethylenvinylacetat und eine Rückseitenverkapselungsstruktur 30 wie beispielsweise eine TEDLAR®-Folie auf. Einlaminierungsbereiche 526, an denen die Einlaminierung der Steckeinrichtung 522 in das Rückseitenverkapselungselement 26 endet, grenzen an Übergangsbereiche 525, die einen Übergang zwischen dem vom Rückseitenverkapselungselement 26 bedeckten Bereich der Steckeinrichtung 522 und dem unbedeckten Bereich der Steckeinrichtung 522 bilden. An den Übergangsbereichen 525 und Einlaminierungsbereichen 526 sind jeweils ein Abdichtmittel 552 und ein Verblendungsbereich 548 angeordnet, um die Übergangsbereiche 525 und die Einlaminierungsbereiche 526 besonders gegen das Eindringen von Wasser und Staub zu schützen. Die Steckeinrichtung 522 ist mit dem Querverbinder 18 mittels des elektrischen Anschlusses 524 elektrisch verschaltet, der die Steckeinrichtung 522 über eine in Richtung des Querverbinders 18 gerichtete Öffnung verlässt. Der elektrische Anschluss 524 ist weiterhin mit dem Kontakt 560 verbunden, der in dem Gehäuse (schwarz gezeichnet) der Steckeinrichtung 522 derart angeordnet ist, dass er gegenüber der Umgebung geschützt ist. Er eignet sich zur Verbindung mit einer komplementären Struktur. Weiterhin weist die Steckeinrichtung 522 zur Verbindung mit der komplementären Struktur Einrastelemente 562 auf, die dazu dienen, die Steckeinrichtung 522 mit der komplementären Struktur derart zu verbinden, dass sie sich nicht von alleine voneinander lösen können.

Fig. 8 zeigt eine Teil-Querschnittsansicht eines weiteren erfindungsgemäßen Solarmoduls 610. Das Solarmodul 610 entspricht dem in Fig. 7 gezeigten Solarmodul 510, auf das hiermit Bezug genommen wird, mit der Ausnahme, dass das Solarmodul 610 eine komplementäre Struktur aufweist. Die komplementäre Struktur weist eine Diode 644 auf, die in einer Chipkarte 666 angeordnet ist. Die Chipkarte 666 umfasst ein flach ausgebildetes Gehäuse. Die Diode 644 und die Chipkarte 666 sind komplementär zu der Steckeinrichtung 522 ausgebildet, sodass die Chipkarte 666 mit der Steckeinrichtung 522 kraft- und formschlüssig verbunden ist, und die Diode 644 den elektrischen Kontakt 560 der Steckeinrichtung 522 kontaktiert. Die Chipkarte 666 und die Diode 644 sind Teil der komplementären Struktur. Die Diode 644 und die Chipkarte 666 sind weiterhin mit einem Stecker 656 verbunden, der weiterhin elektrische Kontaktelemente 668 aufweist, die in einem Gehäuse angeordnet sind. Ein Kabel 640 mit einem elektrischen Kontakt 642 ist weiterhin mit dem Stecker 656 verbunden, wobei der elektrische Kontakt 642 den elektrischen Kontaktelementen 668 kontaktiert. Elektrische Leitungen 670 sind in der Chipkarte 666 und der Diode 644 angeordnet, sodass ein elektrischer Kontakt zwischen den elektrischen Kontaktelementen 668 des Steckers 656 und dem elektrischen Kontakt 560 der Steckeinrichtung 522 besteht. Der Stecker 656 weist Rastelemente 672 auf, die komplementär zu den Einrastelementen 562 der Steckeinrichtung 622 ausgebildet sind, sodass sie ineinandergreifen, aber lösbar sind, wenn erforderlich. Weiterhin sind jeweils die Steckeinrichtung 522 und die Chipkarte 666 und der Stecker 656 jeweils mittels Kleber 674 miteinander verklebt.

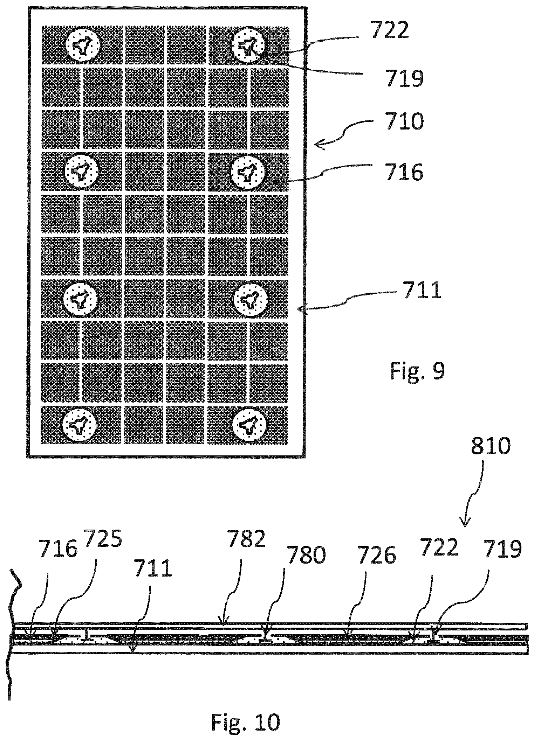

Fig. 9 zeigt eine schematisch dargestellte Aufsicht auf ein weiteres erfindungsgemäßes Solarmodul 710. Die Aufsicht ist auf die Rückseite des Solarmoduls 710 gerichtet, wobei allerdings ein Rückseitenverkapselungselement, Querverbinder und Busbars des Solarmoduls 710 nicht gezeigt sind. Das Solarmodul 710 weist ein Frontseitenverkapselungselement 711 auf, auf dem Solarzellen 716 angeordnet sind. Das Solarmodul 710 weist weiterhin Steckeinrichtungen 722 auf, die auf den Solarzellen 716 bzw. dem Frontseitenverkapselungselement 711 angeordnet sind. Die Steckeinrichtungen 722 weisen jeweils einen Aufnahmebereich 719 zur Verbindung mit einer komplementären Struktur auf. Der Aufnahmebereich 719 ist als Aussparung ausgebildet, die geeignet ist, mit einer komplementären Struktur eine bajonettverschlussartige Verbindung einzugehen. Wie bereits umfassend beschrieben können die Steckeinrichtungen 722 dem Solarmodul 710 abhängig von ihrer Ausbildung mechanische und/oder elektrische Funktionalitäten hinzufügen. Ebenso ist denkbar, dass alle acht Steckeinrichtungen 722 eine rein mechanische Funktion erfüllen und zur rahmenlosen Montage des Solarmoduls und dessen mechanische Fixierung an acht Punkten dienen.

Fig. 10 zeigt eine Teil-Querschnittsansicht eines weiteren erfindungsgemäßen Solarmoduls 810. Das Solarmodul 810 weist ein Frontseitenverkapselungselement 711, Solarzellen 716, ein Rückseitenverkapselungselement 726 und Steckeinrichtungen 722 auf. Die Steckeinrichtungen 722 sind in dem Rückseitenverkapselungselement 26 einlaminiert, sodass jeweils Überlappabschnitte 725 ausgebildet sind, in denen Teile des Rückseitenverkapselungselements 726 jeweils mit Teilen der Steckeinrichtungen 722 überlappt. Die Steckeinrichtungen 722 weisen einen Aufnahmebereich 719 auf, der als eine Aussparung ausgestaltet ist. Jeder Aufnahmebereich 719 ist mit einer komplementären Struktur verbunden. Die komplementäre Struktur weist ein Untergestell 782 auf, an dem Rastelemente 780 angeordnet sind. Die Rastelemente 780 sind in dem jeweiligen Aufnahmebereich 719 derart angeordnet, dass sie einen bajonettartigen Verschluss bilden. Das Untergestell 782 ist geeignet, um an ein Hausdach, eine Fassade und/oder ein Traggestell montiert zu werden.

### Bezugszeichenliste:

- 10: Solarmodul
- 11: Frontseitenverkapselungselement
- 12: Glasplatte
- 14: Einbettungspolymer
- 15: Busbar
- 16: Solarzelle
- 18: Querverbinder
- 19: Aufnahmebereich
- 20: Schicht
- 21: Kontaktfläche
- 22: Steckeinrichtung
- 23: Seite
- 25: Überlappabschnitt
- 26: Rückseitenverkapselungselement
- 28: Einbettungspolymer
- 30: Rückseitenverkapselungsstruktur
- 32: Vertiefung
- 310: Solarmodul
- 319: Aufnahmebereich
- 321: Kontaktfläche
- 322: Steckeinrichtung
- 323: Seite
- 324: elektrischer Kontakt
- 329: Öffnung
- 410: Solarmodul
- 421: Kontaktfläche
- 422: Steckeinrichtung
- 423: Seite
- 424: elektrische Kontakte
- 425: Übergangsbereich
- 426: Einlaminierungsbereich
- 440: Kabel
- 442: Kontakt
- 444: Diode
- 446: Berührungsschutz
- 448: Verblendung
- 452: Dichtmittel
- 454: Abdichtmittel
- 456: Gehäuse
- 510: Solarmodul
- 522: Steckeinrichtung
- 524: elektrischer Anschluss
- 525: Übergangsbereich
- 526: Einlaminierungsbereich
- 548: Verblendung
- 552: Dichtmittel
- 560: Kontakt
- 562: Einrastelement
- 610: Solarmodul
- 640: Kabel
- 642: elektrischer Kontakt
- 644: Diode
- 656: Stecker
- 666: Chipkarte
- 668: elektrische Kontaktelemente
- 670: elektrische Leitung
- 672: Rastelement
- 674: Kleber
- 710: Solarmodul
- 711: Frontseitenverkapselungselement
- 716: Solarzelle
- 719: Aufnahmebereich
- 722: Steckeinrichtung
- 725: Überlappabschnitt
- 726: Rückseitenverkapselungselement
- 780: Untergestell
- 782: Rastelement
- 810: Solarmodul

## Patentansprüche

1. Solarmodul (10, 310, 410, 510, 610, 710, 810) mit einer Frontseitenoberfläche und einer Rückseitenoberfläche, aufweisend
- ein die Frontseitenoberfläche des Solarmoduls bildendes Frontseitenverkapselungselement (11),
- eine Mehrzahl Solarzellen (16, 716), die elektrisch miteinander verschaltet sind,
- ein die Rückseitenoberfläche des Solarmoduls (10, 310, 410, 510, 610, 710, 810) mit einer Rückseitenoberflächenebene bildendes Rückseitenverkapselungselement (26, 726), das eine polymere Kunststofffolie aufweist, und
- mindestens eine Steckeinrichtung (22, 322, 422, 522, 722) zur Verbindung mit einer komplementären Struktur, wobei die Steckeinrichtung (22, 322, 422, 522, 722) zumindest teilweise im Bereich eines Überlappabschnittes (25, 725) in das Rückseitenverkapselungselement (26, 726) einlaminiert ist, wobei das Rückseitenverkapselungselement (26, 726) eine Öffnung aufweist und die Steckeinrichtung (22, 322, 422, 522, 722) zumindest zum Teil in der Öffnung angeordnet ist, **dadurch gekennzeichnet, dass** die Öffnung des Rückseitenverkapselungselements (26, 726) eine Grundfläche aufweist, die kleiner ist als eine Grundfläche der Steckeinrichtung (22, 322, 422, 522, 722) und dass die Steckeinrichtung (22, 322, 422, 522, 722) die Rückseitenoberflächenebene des Solarmoduls (10, 310, 410, 510, 610, 710, 810) um höchstens 15mm, bevorzugt um höchstens 6mm, bevorzugter um höchstens 4mm, überragt.

2. Solarmodul (10, 310, 410, 510, 610, 710, 810) nach Anspruch 1, **dadurch gekennzeichnet, dass**, dass die Steckeinrichtung (22, 322, 422, 522, 722) in Richtung senkrecht zur Rückseitenoberfläche eine maximale Höhe aufweist, die kleiner 10% bevorzugt kleiner 8%, bevorzugter kleiner 5% von einem Durchmesserdurchschnittswert ist, der aus einem maximalen Durchmesser und aus einem minimalen Durchmesser der Steckeinrichtung (22, 322, 422, 522, 722) gebildet ist, die sich in der Aufsicht auf die Rückseitenoberflächenebene darstellen.

3. Solarmodul (10, 310, 410, 510, 610, 710, 810) nach Anspruch 1 oder 2, **dadurch gekennzeichnet, dass** die Steckeinrichtung (22, 322, 422, 522, 722) ein Gehäuse aufweist oder ausbildet.

4. Solarmodul (310, 410, 510) nach einem der vorangehenden Ansprüche, **dadurch gekennzeichnet, dass** die Steckeinrichtung (322, 422) mindestens einen ersten Kontakt (324, 424, 524), der mit den Solarzellen (16) elektrisch verschaltet ist, und mindestens einen zweiten Kontakt (560) aufweist, der geeignet ist, von der komplementären Struktur kontaktiert zu werden.

5. Solarmodul nach einem der vorangehenden Ansprüche, **dadurch gekennzeichnet, dass** die Steckeinrichtung mindestens einen elektrischen Anschluss, mindestens eine Diode und/oder mindestens eine Bypass-Diode aufweist.

6. Solarmodul (10, 310) nach einem der vorangehenden Ansprüche, **dadurch gekennzeichnet, dass** die Steckeinrichtung (22, 322) eine Kontaktfläche (21, 321) zur Verbindung der komplementären Struktur aufweist, die planparallel zu oder in der Rückseitenoberflächenebene angeordnet ist.

7. Solarmodul nach einem der vorangehenden Ansprüche 3 bis 6, **dadurch gekennzeichnet, dass** das Gehäuse mindestens zwei Teile aufweist und mindestens ein einlaminierter Bereich von zumindest einem Teil mindestens eine Öffnung aufweist, die eine kraftschlüssige Verbindung zwischen den Teilen des Gehäuses gestattet.

8. Solarmodul (10) nach einem der vorangehenden Ansprüche, **dadurch gekennzeichnet, dass** die Steckeinrichtung (22) in einem Einlaminierungsbereich, in dem die Steckeinrichtung (22) in das Rückseitenverkapselungselement (26) einlaminiert ist, Vertiefungen (32) aufweist, die geeignet sind, um Rückseitenverkapselungselementmaterial aufzunehmen.

9. Solarmodul nach einem der vorangehenden Ansprüche, **dadurch gekennzeichnet, dass** die Steckeinrichtung mindestens einen Abstandshalter aufweist, der sich zwischen Solarzellen erstreckt und sich auf dem Frontseitenverkapselungselement abstützt.

10. Solarmodul (410, 610, 710) nach einem der vorangehenden Ansprüche, **dadurch gekennzeichnet, dass** es weiterhin die komplementäre Struktur umfasst und die komplementäre Struktur mit der Steckeinrichtung (422, 522, 722) verbunden ist.

11. Solarmodul (710) nach einem der vorangehenden Ansprüche, **dadurch gekennzeichnet, dass** die komplementäre Struktur und die Steckeinrichtung (722) bajonettverschlussartig miteinander verbunden sind.

12. Solarmodul (410) nach einem der vorangehenden Ansprüche, **dadurch gekennzeichnet, dass** die Steckeinrichtung (422) und/oder die komplementäre Struktur eine Dichtung (452) aufweisen, die derart gestaltet ist, dass der Verbindungsbereich, in dem die komplementäre Struktur mit der Steckeinrichtung (422) verbindbar ist, abgedichtet ist.

13. Solarmodul (410) nach einem der vorangehenden Ansprüche, **dadurch gekennzeichnet, dass** die Steckeinrichtung (422) und/oder die komplementäre Struktur ein Abdichtungselement (454) aufweisen, das derart angeordnet ist, dass es einen Übergangsbereich (425) abdeckt, der den Übergang eines einlaminierten Teils der Steckeinrichtung (422) und eines unbedeckten Teils der Steckeinrichtung (422) darstellt.

14. Solarmodul (410, 610) nach einem der vorangehenden Ansprüche 9 bis 12, **dadurch gekennzeichnet, dass** die komplementäre Struktur mindestens einen elektrischen Anschluss (670), mindestens eine Diode (444, 644) und/oder mindestens eine Bypass-Diode enthält.

15. Solarmodul (410, 610) nach einem der vorangehenden Ansprüche, **dadurch gekennzeichnet, dass** die Steckeinrichtung (422, 522) und/oder die komplementäre Struktur unlösbar mit mindestens einem Kabel (440, 640) verbunden ist.

## Claims

1. A solar module (10, 310, 410, 510, 610, 710, 810) having a front surface and a back surface, comprising
- a front encapsulation member (11) forming the front surface of the solar module,
- a plurality of solar cells (16, 716) electrically interconnecting each other,
- a back encapsulation element (26, 726) forming the back surface of the solar module (10, 310, 410, 510, 610, 710, 810) and having a polymeric plastic film, and
- at least one plug-in device (22, 322, 422, 522, 722) for connection to a complementary structure, wherein the plug-in device (22, 322, 422, 522, 722) is at least partially laminated in the region of an overlap section (25, 725) in the back encapsulation element (26, 726), wherein the back encapsulation element (26, 726) has an opening and the plug-in device (22, 322, 422, 522, 722) is at least partially disposed in the opening, **characterized in that** the opening of the back encapsulation element (26, 726) has a basic area which is smaller than a basic area of the plug-in device (22, 322, 422, 522, 722) and that the plug-in device (22, 322, 422, 522, 722) surmounts the back surface plane of the solar module (10, 310, 410, 510, 610, 710, 810) by at most 15mm, preferably at most 6mm, more preferably at most 4mm.

2. The solar module (10, 310, 410, 510, 610, 710, 810) according to claim 1, **characterized in that** the plug-in device (22, 322, 422, 522, 722) in the direction perpendicular to the back surface has a maximum height which is less than 10%, preferably less than 8%, more preferably less than 5%, of a diameter average formed from a maximum diameter and a minimum diameter of the plug-in device (22, 322, 422, 522, 722) which present in a plan view on the back surface plane.

3. The solar module (10, 310, 410, 510, 610, 710, 810) according to claim 1 or 2, **characterized in that** the plug-in device (22, 322, 422, 522, 722) comprises or forms a housing.

4. The solar module (310, 410, 510) according to one of the preceding claims, **characterized in that** the plug-in device (322, 422) has at least one first contact (324, 424, 524), which is electrically connected to the solar cell (16), and at least one second contact (560) adapted to be contacted by the complementary structure.

5. The solar module according to one of the preceding claims, **characterized in that** the plug-in device has at least one electrical connection, at least one diode and / or at least one bypass diode.

6. The solar module (10, 310) according to one of the preceding claims, **characterized in that** the plug-in device (22, 322) has a contact area (21, 321) for connecting the complementary structure, which is arranged plane-parallel to or in the back surface plane.

7. The solar module according to one of the preceding claims 3 to 6, **characterized in that** the housing has at least two parts and at least one laminated portion of at least one part has at least one opening which allows a frictional connection between the parts of the housing.

8. The solar module (10) according to one of the preceding claims, **characterized in that** the plug-in device (22) has in a lamination region, in which the plug-in device (22) is laminated in the back encapsulation element (26), recesses (32) which are suitable to receive backside encapsulation element material.

9. The solar module according to one of the preceding claims, **characterized in that** the plug-in device has at least one spacer which extends between solar cells and is supported on the front encapsulation element.

10. The solar module (410, 610, 710) according to any one of the preceding claims, **characterized in that** it further comprises the complementary structure and the complementary structure is connected with the plug-in device (422, 522, 722).

11. The solar module (710) according to any one of the preceding claims, **characterized in that** the complementary structure and the plug-in device (722) are connected to one another in a bayonet-like manner.

12. The solar module (410) according to one of the preceding claims, **characterized in that** the plug-in device (422) and / or the complementary structure have a seal (452) which is designed such that the connection region, in which the complementary structure is connectable with the plug-in device (422), is sealed.

13. The solar module (410) according to one of the preceding claims, **characterized in that** the plug-in device (422) and / or the complementary structure have a sealing element (454), which is arranged such that it covers a transition region (425) being the transition of a laminated part of the plug-in device (422) and an uncovered part of the plug-in device (422).

14. The solar module (410, 610) according to any one of the preceding claims 9 to 12, **characterized in that** the complementary structure includes at least one electrical connection (670), at least one diode (444, 644) and / or at least one bypass diode.

15. The solar module (410, 610) according to any one of the preceding claims, **characterized in that** the plug-in device (422, 522) and / or the complementary structure is permanently connected to at least one cable (440, 640).

## Revendications

1. Un module solaire (10, 310, 410, 510, 610, 710, 810) ayant une surface avant et une surface arrière, comprenant
- un élément d'encapsulation avant (11) formant la surface avant du module solaire,
- une pluralité de cellules solaires (16, 716) connectées électriquement l'une à l'autre,
- un élément d'encapsulation arrière (26, 726) formant la surface arrière du module solaire (10, 310, 410, 510, 610, 710, 810) et comportant un film plastique polymère, et
- au moins un dispositif enfichable (22, 322, 422, 522, 722) pour la connexion à une structure complémentaire, dans lequel le dispositif enfichable (22, 322, 422, 522, 722) est au moins partiellement laminé dans la région d'une section de chevauchement (25, 725) dans l'élément d'encapsulation arrière (26, 726), dans lequel l'élément d'encapsulation arrière (26, 726) présente une ouverture et le dispositif enfichable (22, 322, 422, 522, 722) est au moins partiellement disposé dans l'ouverture, **caractérisé en ce que** l'ouverture de l' élément d'encapsulation arrière (26, 726) a une superficie qui est plus petite qu'une superficie du dispositif enfichable (22, 322, 422, 522, 722) et que le dispositif enfichable (22, 322, 422, 522, 722) surmonte le plan de la surface arrière du module solaire (10, 310, 410, 510, 610, 710, 810) d'au plus 15 mm, de préférence d'au plus 6 mm, mieux encore d'au plus 4mm.

2. Le module solaire (10, 310, 410, 510, 610, 710, 810) selon la revendication 1, **caractérisé en ce que** le dispositif enfichable (22, 322, 422, 522, 722) a dans la direction perpendiculaire à la surface arrière une hauteur maximale qui est d'au moins de 10%, de préférence d'au moins de 8%, mieux encore d'au moins de 5% inférieur à un diamètre moyen formé d'un diamètre maximal et d'un diamètre minimal du dispositif enfichable (22, 322, 422, 522, 722) se présentant en vue de dessus sur le plan de surface arrière.

3. Le module solaire (10, 310, 410, 510, 610, 710, 810) selon la revendication 1 ou 2, **caractérisé en ce que** le dispositif enfichable (22, 322, 422, 522, 722) comprend ou forme un boîtier.

4. Le module solaire (310, 410, 510) selon l'une des revendications précédentes, **caractérisé en ce que** le dispositif enfichable (322, 422) comporte au moins un premier contact (324, 424, 524) relié électriquement à la cellule solaire (16) et au moins un second contact (560) adapté pour être mis en contact par la structure complémentaire.

5. Le module solaire selon l'une des revendications précédentes, **caractérisé en ce que** le dispositif enfichable présente au moins une connexion électrique, au moins une diode et / ou au moins une diode de dérivation.

6. Le module solaire (10, 310) selon l'une des revendications précédentes, **caractérisé en ce que** le dispositif enfichable (22, 322) présente une surface de contact (21, 321) pour connecter la structure complémentaire, qui est disposée plane et parallèle à ou dans le plan de surface arrière.

7. Le module solaire selon l'une des revendications précédentes 3 à 6, **caractérisé en ce que** le boîtier comporte au moins deux parties et au moins une partie stratifiée d'au moins une partie présente au moins une ouverture permettant une connexion par friction entre les parties du boîtier.

8. Le module solaire (10) selon l'une des revendications précédentes, **caractérisé en ce que** le dispositif enfichable (22) a dans une zone de stratification, dans lequel le dispositif enfichable (22) est laminé dans l'élément d'encapsulation arrière (26), des évidements (32) appropriés de recevoir un matériau de l'élément d'encapsulation arrière.

9. Le module solaire selon l'une des revendications précédentes, **caractérisé en ce que** le dispositif enfichable présente au moins une entretoise qui s'étend entre les cellules solaires et est supportée par l'élément d'encapsulation avant.

10. Le module solaire (410, 610, 710) selon l'une quelconque des revendications précédentes, **caractérisé en ce qu'**il comprend en outre la structure complémentaire et que la structure complémentaire est connectée au dispositif enfichable (422, 522, 722).

11. Le module solaire (710) selon l'une quelconque des revendications précédentes, **caractérisé en ce que** la structure complémentaire et le dispositif enfichable (722) sont reliés l'un à l'autre à la manière d'une baïonnette.

12. Le module solaire (410) selon l'une des revendications précédentes, **caractérisé en ce que** le dispositif enfichable (422) et / ou la structure complémentaire comportent un joint d'étanchéité (452) conçu de telle sorte que la zone de connexion, dans laquelle la structure complémentaire est connectable au dispositif enfichable (422), est scellée.

13. Le module solaire (410) selon l'une des revendications précédentes, **caractérisé en ce que** le dispositif enfichable (422) et / ou la structure complémentaire comportent un élément d'étanchéité (454) agencé de manière à recouvrir une région de transition (425) qui représente la transition d'une partie stratifiée du dispositif enfichable (422) et d'une partie non couverte du dispositif enfichable (422).

14. Le module solaire (410, 610) selon l'une quelconque des revendications précédentes 9 à 12, **caractérisé en ce que** la structure complémentaire comprend au moins une connexion électrique (670), au moins une diode (444, 644) et / ou au moins une diode de dérivation.

15. Le module solaire (410, 610) selon l'une quelconque des revendications précédentes, **caractérisé en ce que** le dispositif enfichable (422, 522) et / ou la structure complémentaire sont connectés en permanence à au moins un câble (440, 640).
